# EUROPEAN PATENT APPLICATION

(11) **EP 0 714 172 A2**
(43) Date of publication of application: **29.05.1996**
(21) Application number: 95308284.9
(22) Date of filing: 20.11.1995
(51) Int. Cl.: H03M 7/30

(54) **Data compression**

(30) Priority: 23.11.1994 US 344759
(71) Applicant: International Business Machines Corporation, Armonk, N.Y. 10504 (US)
(72) Inventor: Craft, David J., Austin, Texas 78746-4300 (US)
(74) Representative: Lloyd, Richard Graham

(57) **Abstract**

A method and system for permitting effective data compression in a system which employs short message lengths. A history buffer in association with each sender and receiver within the system has a length substantially longer than the average length of a data message. Every message to be transmitted by the sender over an extended period of time is then stored within the associated history buffer at the sender and at the receiver such that the history buffer will eventually be filled. This is accomplished by maintaining the history buffer at a current state despite a temporary cessation of data transmission between the sender and receiver. Each time a new message is to be transmitted by the sender the content of the message as compared to the content of the history buffer to determine if a match exists between some portion of the message and some portion of the content of the history buffer. If a match occurs, a pointer to the matching portion within the history buffer is transmitted in place of the portion of the message and the message portion is then reconstructed at the receiver, greatly reducing the data transmission requirements. The history buffer is preferably provided utilizing a content addressable memory in order to enhance the efficiency of match determination and speed.

## Description

The present invention relates in general to data compression techniques of the type which utilize repetition within the message stream to provide data compression. More particularly, the present invention relates to data compression in systems which employ short message lengths.

Data compression has long been recognized as a desirable feature in data communication systems wherein large amounts of data are transmitted. One technique for implementing such data compression is a so-called "string matching" technique in which characters of the data stream are matched against characters of the previous transmitted data. This algorithm is based upon the simple observation that, in a continuous data stream, some data occur more than once and in particular may occur many times within a local region of the data stream. For example, in a stream of text data, the word "the" is likely to appear frequently. If the data source keeps track of the history of data recently sent (by storing that data in a so-called "history buffer"), the data source may find redundant occurrences of a sequence of data by comparing successive elements of the current data which is to be transmitted with successive elements of stored historical data. This process of comparison is called string matching.

One algorithm for performing this adaptive type of data compression is the Lempel _ Ziv_1 (LZ1) algorithm which utilizes a sliding window or history buffer which retains previously processed data. An identical copy of this history data is created at the receiver and utilized in the decompression process.

when utilizing LZ1 compression, each byte of incoming data is stored within the history buffer which may then be viewed as a byte wide shift register. For each new byte which is shifted into this register a byte is shifted out at the other end. The register or history buffer thus holds the most recent data processed and is in effect, a sliding window on this data, which extends from a point at some point in the past until the present.

The LZ1 algorithm achieves compression by identifying situations where an incoming string or sequence of data bytes has occurred earlier, and is still available within the history buffer. Such strings are encoded typically as a two element pointer (offset, length) describing the location within the history buffer of the start of the string and the length of that string. Compression results if fewer bits are required to encode that pointer than would be required for the data byte string itself.

Those skilled in the art will appreciate that depending upon the size of history buffer utilized and the specifics of the coding utilized for the offset and length components of the pointer there are certain minimum length strings for which compression of the data stream will result. The history buffer sizes utilized for the LZ1 algorithm are typically within the range of 512 to 4,096 bytes. Although longer data streams may be found with larger history sizes, more bits are typically needed to represent the offset values in such situations and thus, compression is not necessarily improved. The length of these matching data strings are usually highly skewed, shorter values tending to predominate. Variable length codes, typically 2 to 12 or more bits, are therefore utilized to represent these values, more compact codes being assigned to the predominant values.

As a result, most LZ1 implementations may encode pointers for even a 2 byte data string and achieve compression, since the bits required to encode such a pointer are less than those bits which are needed to represent the same bytes of data explicitly. Of course, it is also necessary to provide a method for encoding single data bytes which are either not currently within the history buffer or do not form part of at least a 2 byte string. One commonly utilized scheme is to encode such bytes literally, embedding the actual data within another pointer type. A single tag bit is commonly utilized to distinguish between the two types of pointers, those which give the offset and length (2 or more bytes) of a string which is currently within this history buffer, and those which simply contain one byte of embedded data.

Thus, the output from a typical LZ1 compressor generally consists of LITERAL and COPY pointers in some sequence, each pointer prefixed by a tag bit to identify its pointer type. The history buffer is always set to a known state at the start of the compression operation, typically empty. Thus, it is usual for the first pointer, at least, to always be LITERAL. As the data is processed and the history buffer fills, it becomes more likely that a 2 or more byte matching sequence will occur which can be encoded as a COPY pointer.

The LZ1 decompression process relies on the creation of a history buffer at the receiver which is maintained in an identical state to that which is utilized at the sender. In order to accomplish this both the sender and receiver must begin with identical data in their respective history buffers. Most LZ1 implementations achieve this just by clearing the history buffer at the start of operation. It should be noted that the history buffer at the sender and receiver are not necessarily identical at all times, in view of processing which occurs at the sender, such that the history buffer at the sender is slightly ahead of the history buffer at the receiver.

One problem with adaptive LZ1 data compression is that this technique is not typically effective if the amount of data to be compressed is small. The history buffer is empty at the beginning of operation and initially there is very little chance that the current data string will match a portion of the history buffer, which is necessary in order to achieve compression. Only a data stream containing mostly runs of identical characters may be effectively compressed in small amounts. Typically it is necessary that the data amount being transmitted is at least four times the length of the history buffer size in order to achieve effective compression. Thus, if the history buffer size is 512 bytes, a minimum message length or packet size of 2,000 bytes is required in order for LZ1 compression to be effective.

This invention is directed to providing an improved method and system for providing effective data compression in a system which employs short message lengths.

To achieve this, the invention provides a system for data compression in a data communication system comprising a sender and a receiver wherein said data communication comprises discrete data messages, said system comprising: a first history buffer at said sender, said first history buffer having a length substantially longer than the length of said data messages; a second history buffer at said receiver, said second history buffer having a length at least equal to the length of said first history buffer; the sender being arranged to sequentially store a plurality of said data messages to be transmitted from said sender to said receiver over an extended period of time within said first history buffer; the receiver being arranged to sequentially store said plurality of data messages received at said receiver from said sender over said extended period of time within said second history buffer; means at the sender for comparing each individual data message to be transmitted from said sender to said receiver with the content of said first history buffer; means for transmitting a pointer value from said sender to said receiver in place of a portion of a selected data message to be transmitted in response to a match between a portion of said selected short length data message and a particular portion of said content of said first history buffer, said pointer value identifying a location of said particular portion within said first history buffer; and means at the receiver for retrieving a portion of said second history buffer corresponding to said particular portion of said first history buffer at said receiver whereby transmission of said portion of said selected data message is eliminated.

More particularly, the present invention permits effective data compression in a system which employs short message lengths by providing a history buffer in association with each sender and receiver within the system having a length substantially longer than the average length of a data message. Every message to be transmitted by the sender over an extended period of time is then stored within the associated history buffer at the sender and at the receiver such that the history buffer will eventually be filled. This is accomplished by maintaining the history buffer at a current state despite a temporary cessation of data transmission between the sender and receiver. Each time a new message is to be transmitted by the sender the content of the message as compared to the content of the history buffer to determine if a match exists between some portion of the message and some portion of the content of the history buffer. If a match occurs, a pointer to the matching portion within the history buffer is transmitted in place of the portion of the message and the message portion is then reconstructed at the receiver, greatly reducing the data transmission requirements. The history buffer is preferably provided utilizing a content addressable memory in order to enhance the efficiency of match determination.

The invention will best be understood by reference to the following detailed description of an illustrative embodiment when read in conjunction with the accompanying drawings, wherein:
**Figure 1** is a partially schematic pictorial representation of a data processing system;
**Figure 2** is a pictorial representation of a history buffer and data message; and
**Figure 3** is a high level logic flowchart which illustrates the method of the present implementation.

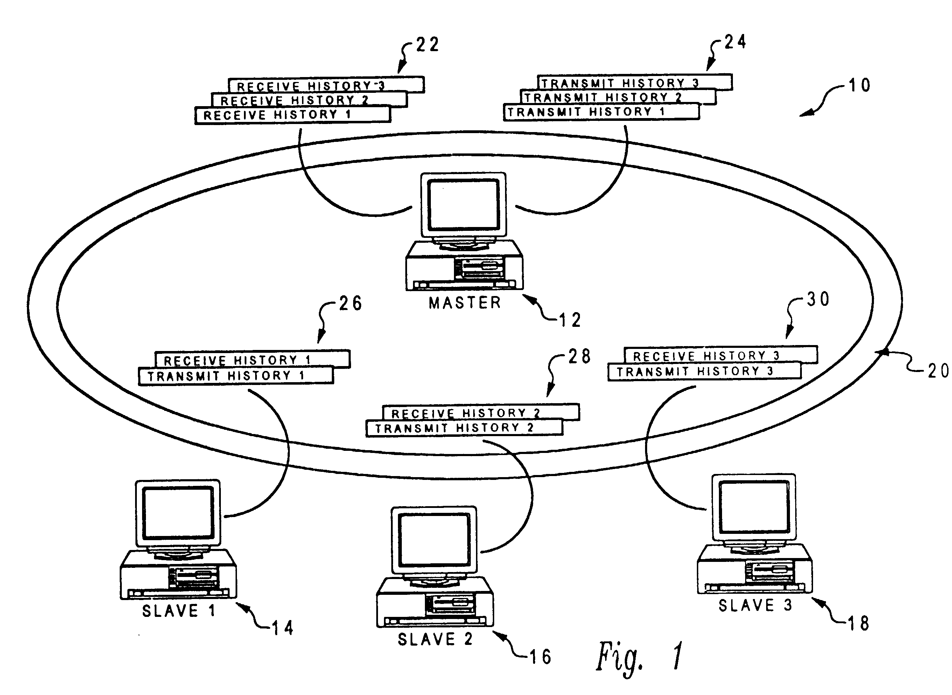

With reference now to the figures and in particular with reference to **Figure 1**, there is depicted a partially schematic pictorial representation of a data processing system **10**. As illustrated, data processing system **10** comprises a master station **12** which is coupled to slave stations **14, 16** and **18** via network **20**. As those skilled in the art will appreciate master station **12** and slave stations **14, 16** and **18** may be implemented utilizing personal computers, terminals or any other suitable communication device.

In the depicted embodiment within **Figure 1**, master station **12** includes a plurality of receive history buffers **22** associated therewith as well as a plurality of transmit history buffers **24**. Similarly, each slave station includes an associated transmit history buffer and receive history buffer. Thus, slave station **14** includes transmit history buffer and receive history buffer **26** while slave station **16** includes transmit history buffer and receive history buffer **28**. Similarly, slave station **18** includes transmit history buffer and receive history buffer **30**. Of course, those skilled in the art will appreciate that the provision of separate transmit and receive history buffers provides for additional efficiency in data compression wherein the characteristics of the transmit data stream and receive data stream differ. In those situations in which the transmit and receive data stream include substantial similarity a single history buffer associated with each slave station and its duplicate maintained at master station **12** will suffice.

Next, each receive history buffer and transmit history buffer throughout data processing system **10** is preferably initialized in an empty state at a predetermined time. Examples of this technique may be the reinitialization of each history buffer at a selected time or date during operation of data processing system **10**, or the reinitialization of each history buffer at the beginning of an extended communications session which includes multiple episodes of communications. Thereafter, short data length messages transmitted between slave station **14**, for example, and master station **12** are stored within an appropriate history buffer prior to transmission and compared with the content of that history buffer for possible repetition and subsequent data compression prior to transmission. Of course, during the initial communication between a slave station and master station **12** it is unlikely that data compression will occur as the history buffers have been initialized in an empty condition.

As will be explained in greater detail herein, in a manner unlike known LZ1 data compression techniques, the history buffers associated with the slave stations and master station **12** are not reinitialized following a transmission of a short length message. Rather, each history buffer is maintained for some extended period of time, such as, for example, an entire communication session, or a fixed period of time, such as twenty-four hours. In this manner, effective data compression can be achieved utilizing the LZ1 technique in systems such as that illustrated within **Figure 1** wherein communication between a master station and multiple slave station occurs utilizing short data length message. Examples of this type of network are various point-of-sale systems, automated teller machine systems or similar networks in which a large number of short length communications are transmitted between multiple stations within the network. By maintaining the content of each associated history buffer over an extended period of time effective data compression may be achieved despite the utilization of short data length messages.

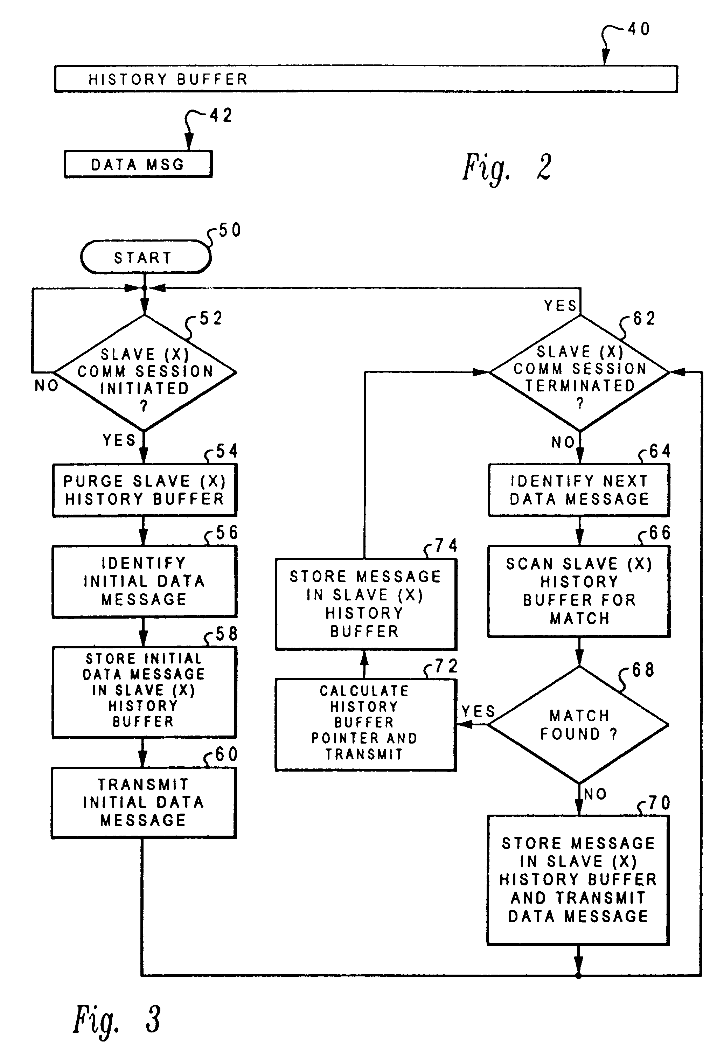

Referring now to **Figure 2**, there is depicted a pictorial representation of a history buffer and data message. As illustrated, history buffer **40** is substantially longer than data message **42.** History buffer **40** is preferably implemented utilizing a content addressable memory, to enhance the efficiency of match determination. Those having ordinary skill in the art will appreciate that history buffer **40** is preferably of a length suitable for implementation of the LZ1 algorithm and, prior to the present invention, systems which utilized data messages of a length such as that pictorially illustrated at data message **42** within **Figure 2** could not effectively implement this data compression technique.

Finally, with reference now to **Figure 3**, there is depicted a high level logic flowchart which illustrates the method of the present implementation, which may be implemented within master station **12**. As illustrated this process begins at block **50** and thereafter passes to block **52**. Block **52** illustrates a determination of whether or not a communication session has been initiated with a particular slave station and if not, the process merely iterates until such time as a communication session has been initiated. For purposes of this specification a "communication session" shall constitute either a specified session which takes place over an extended period of time and which includes multiple episodes of communications or the initiation of a predetermined extended period of time, such as twenty-four hours, between a particular slave station and a master station. Of course, multiple communication sessions may occur simultaneously, with each message or episode identified as belonging to a particular slave station by an associated message "header" or other suitable identifier.

Next, the process passes to block **54** which illustrates the purging of the history buffer associated with that particular slave station. Of course, in systems in which a separate receive history buffer and transmit history buffer are provided both the receive and transmit history buffer must be purged.

Next, the initial data message is identified, as depicted at block **56** and that initial data message is then stored within the history buffer, as illustrated at block **58**.

Thereafter, that initial data message is transmitted, as depicted at block **60**. Next, the process passes to block **62**. Block **62** illustrates a determination of whether or not the communication session with this slave station has terminated. As described above, this shall occur upon the terminating of some extended communication session or upon the elapse of some specified extended period of time. In either situation, the length of the communication session is chosen such that multiple messages over an extended period of time will be stored within an associated history buffer without the purging of that history buffer. In the event the communication session is terminated, the process returns, in an iterative fashion, to block **52** to await the initiation of the next communication session.

Still referring to block **62**, in the event the communication session with this slave station has not terminated, the process passes to block **64**. Block **64** illustrates the identification of the next data message to be transmitted. Thereafter, the process passes to block **66** which illustrates the scanning of the history buffer associated with this slave station for a match between a portion of this data message and a portion of the content of that history buffer. As described above, each history buffer preferably comprises a content addressable memory and the scanning of that history buffer for a match between a portion of the next data message to be transmitted and a portion of the content of that history buffer may be simply and efficiently accomplished.

Next, the process passes to block **68**. Block **68** illustrates a determination of whether or not a match has been found between a portion of the next data message and a portion of the content of the history buffer for this slave station. Still referring to block **68**, in the event a match is found between a portion of this data message and a portion of the content within the appropriate history buffer, the process passes to block **72**. Block **72** illustrates the calculation of the history buffer pointer (and offset value) and the transmission of that data to the recipient of the data message. The actual message is then stored within the history buffer associated with that slave station, as depicted at block **74** and the process then returns to block **62**, in an iterative fashion, to determine whether or not the communication session remains active.

Referring again to block **68**, in the event no match is found between a portion of the next data message and a portion of the content of the history buffer, the process passes to block **70.** Block **70** illustrates the storing of that message within the history buffer for that slave station and the transmitting of the actual message to the recipient. The process then returns in an iterative fashion, to block **62**, as described above.

Of course, those skilled in the art will appreciate that a data message which has been compressed utilizing this technique must be reconstructed at the recipient station. This may be simply and efficiently accomplished utilizing the history buffer pointer and offset information which has been transmitted and the content of the corresponding history buffer at the recipient station. Additionally, as described above, in the event the actual message has been transmitted, a pointer identifying that message as a LITERAL byte is included and no reconstruction at the recipient station will be necessary beyond the stripping of the LITERAL pointer. In either event, an important feature of the present system is the maintenance of the history buffer between two communication stations employing short length data messages over some extended period of time, in order to permit the history buffer to eventually contain sufficient data to allow effective data compression.

While the invention has been particularly shown and described with reference to a preferred embodiment, it will be understood by those skilled in the art that various changes in form and detail may be made therein without departing from the scope of the invention.

## Claims

1. A system for data compression in a data communication system comprising a sender and a receiver wherein said data communication comprises discrete data messages, said system comprising:
a first history buffer at said sender, said first history buffer having a length substantially longer than the length of said data messages;
a second history buffer at said receiver, said second history buffer having a length at least equal to the length of said first history buffer;
the sender being arranged to sequentially store a plurality of said data messages to be transmitted from said sender to said receiver over an extended period of time within said first history buffer;
the receiver being arranged to sequentially store said plurality of data messages received at said receiver from said sender over said extended period of time within said second history buffer;
means at the sender for comparing each individual data message to be transmitted from said sender to said receiver with the content of said first history buffer;
means for transmitting a pointer value from said sender to said receiver in place of a portion of a selected data message to be transmitted in response to a match between a portion of said selected short length data message and a particular portion of said content of said first history buffer, said pointer value identifying a location of said particular portion within said first history buffer; and
means at the receiver for retrieving a portion of said second history buffer corresponding to said particular portion of said first history buffer at said receiver whereby transmission of said portion of said selected data message is eliminated.

2. A system as claimed in Claim 1, wherein the predetermined extended period of time defines an entire communications session.

3. A system as claimed in Claim 1 or Claim 2, wherein said predetermined extended period of time is an entire day.

4. A system as claimed in any preceding claim, wherein said portion of said selected data message consists of two bytes.

5. A system as claimed in any preceding claim, wherein said first history buffer and/or said second history buffer comprises a content addressable memory.

6. A method for data compression during data communication between a sender and a receiver in a data communication system as claimed in any preceding claim, said method comprising the steps of:
sequentially storing a plurality of said data messages to be transmitted from said sender to said receiver over a predetermined extended period of time within said first history buffer;
sequentially storing said plurality of said data messages received at said receiver from said sender over said predetermined extended period of time within said second history buffer;
comparing each individual data message to be transmitted from said sender to said receiver with the content of said first history buffer;
transmitting a pointer value from said sender to said receiver in place of a portion of a selected data message to be transmitted in response to a match between a portion of said selected data message and a particular portion of said content of said first history buffer, said pointer value identifying a location of said particular portion within said first history buffer; and
retrieving a portion of said second history buffer corresponding to said particular portion of said first history buffer at said receiver wherein transmission of said portion of said selected data message is eliminated.

7. A method for effective data compression during data communication between a sender and a receiver wherein said data communication comprises short length data messages, said method comprising the steps of:
providing a first history buffer at said sender, said first history buffer having a length substantially longer than the length of one of said short length data messages;
providing a second history buffer at said receiver, said second history buffer having a length equal to the length of said first history buffer;
sequentially storing a plurality of short length data messages to be transmitted from said sender to said receiver over a predetermined extended period of time within said first history buffer;
sequentially storing said plurality of short length data messages received at said receiver from said sender over said predetermined extended period of time within said second history buffer;
comparing each individual short length data message to be transmitted from said sender to said receiver with the content of said first history buffer;
transmitting a pointer value from said sender to said receiver in place of a portion of a selected short length data message to be transmitted in response to a match between a portion of said selected short length data message and a particular portion of said content of said first history buffer, said pointer value identifying a location of said particular portion within said first history buffer; and
retrieving a portion of said second history buffer corresponding to said particular portion of said first history buffer at said receiver wherein transmission of said portion of said selected short length data message is eliminated.
